## Europäisches Patentamt
## European Patent Office
## Office européen des brevets

(11) Veröffentlichungsnummer: **0 056 468**
**A2**

(12) # EUROPÄISCHE PATENTANMELDUNG

(21) Anmeldenummer: **81110494.2**

(22) Anmeldetag: **16.12.81**

(51) Int. Cl.³: **H 03 K 3/00**
**H 03 K 5/15**

(30) Priorität: **16.01.81 DE 3101169**

(43) Veröffentlichungstag der Anmeldung:
**28.07.82 Patentblatt 82.30**

(84) Benannte Vertragsstaaten:
**DE FR GB**

(71) Anmelder: **Hewlett-Packard GmbH**
**Herrenberger Strasse 110**
**D-7030 Böblingen(DE)**

(72) Erfinder: **Becker, Josef**
**Erdmannhäuser Strasse 17/1**
**D-7142 Marbach/Neckar(DE)**

(74) Vertreter: **Luberichs, Albert, Dipl.-Ing.**
**c/o Hewlett-Packard GmbH Herrenberger Strasse 110**
**D-7030 Böblingen(DE)**

(54) **Schaltung zur Erzeugung von Impulsen bzw. logischen Signalen.**

(57) Bei einer Schaltung zur Erzeugung von Impulsen bzw. logischen Signalen mit variablen Zustandspegeln, mit einer Umschalteinrichtung zum abwechselnden Aufschalten von den Zustandspegeln entsprechenden variablen Spannungsquellen auf den Ausgang der Schaltung weist die Umschalteinrichtung eine Diodenbrücke in Konfiguration einer Graetz-Schaltung auf, deren gleiche Diodenelektroden zusammenfassenden Eckpunkte mit je einer der den Zustandspegeln entsprechenden Spannungsquellen verbunden sind und deren ungleiche Diodenelektroden zusammenfassenden Eckpunkte mit je einem von zwei komplementären Ausgängen und mit je einer von zwei gleichen, aber entgegengesetzt gepolten Feststromquellen verbunden sind. Diese Feststromquellen sind entsprechend einem Steuersignal umpolbar. Die den Zustandspegeln entsprechenden Spannungsquellen enthalten Operationsverstärker, in deren Rückkopplungszweigen je eine weitere mit den Dioden der Diodenbrücke gleichartige Diode liegt, denen der gleiche Strom wie der der Feststromquellen eingeprägt ist und die so gepolt sind, daß der Einfluß der Spannungsabfälle in der Diodenbrücke auf die Zustandspegel am Ausgang kompensiert wird.

FIG.1

SCHALTUNG ZUR ERZEUGUNG VON IMPULSEN BZW. LOGISCHEN SIGNALEN

Die Erfindung betrifft eine Schaltung gemäß dem Oberbegriff des Anspruchs 1.

Bei vielen Anwendungsfällen von Impulsgeneratoren, Datengeneratoren, Testgeräten für digitale Schaltungen u.ä. ist es erforderlich, daß die beiden Zustandspegel bzw. die Impulsamplituden durch äußere Einstellung am Gerät oder durch ein vorgegebenes Programm veränderbar sind.

Es ist bekannt, die Höhe der Zustandspegel mittels einer Stromverteilungssteuerung zu steuern (Hewlett-Packard Modell 8160A Operating and Service Manual, Seite 8-152 ff.). Dafür werden geeignete dimensionierte Analog-Multiplizierer benutzt. Die Präzision der Impulsamplitudeneinstellung hängt dabei von der elektrischen Symmetrie der Halbleiter-Stromschalter über dem gesamten benutzten Kennlinienbereich ab. Auch müssen die Stromteilerzweige zueinander symmetrisch sein. Der auftretende Fehler läßt sich bei den bekannten Schaltungen, auch wenn diese als integrierte Schaltungen ausgeführt sind, kaum kleiner als 1 % halten. Außerdem neigen sie zum Überschwingen, und es werden durch die Stromschaltertransistoren Störspitzen in das Ausgangssignal eingekoppelt.

Bekannt ist auch die Methode der Summenstrom-Variation eines Differenzverstärkers zur Erzeugung der variablen Zustandspegel, entsprechend dem anderen Steuereingang der analogen Multiplizierschaltung (Hewlett-Packard Modell 8016A Operating and Service Manual Seite 4-57 ff.) Eine nach dieser Methode arbeitende Schaltung hat den Vorteil, daß sich der amplitudenbestimmende Summenstrom präzise regeln läßt. Jedoch besteht auch hier das

- 2 -

0056468

Problem der Störspitzeneinkopplung und der Neigung zum Überschwingen.

Weiterhin ist es bekannt, zwei variable Spannungsquellen, die auf den oberen und den unteren Bezugspegel eingestellt sind, über je einen elektronischen Schalter, zum Beispiel einen Feldeffekttransistor, abwechselnd auf die Ausgangsleitung zu schalten (Aufsatz von B.E. Sear in Computer Design, Mai 1972). Eine solche Schaltung hat den Vorteil, daß sie ohne einen linearen Nachverstärker zur Erzeugung der notwendigen Ausgangsleistung des Impuls- bzw. Datensignals auskommt. Als genauigkeitsbegrenzendes Element muß hier der Bahnwiderstand der elektronischen Schalter beachtet werden. Soll er klein sein, müssen zum Beispiel Feldeffekt-Schalttransistoren mit großflächiger Struktur eingesetzt werden. Solche Schalttransistoren verursachen aber über ihre inneren Kapazitäten die Einkopplung von nicht zu vernachlässigenden Störspitzen aus dem Ansteuersignal in das Ausgangssignal.

Bei Schaltungen zur Erzeugung einer variablen Impulsanstiegszeit bei festen Bezugspegeln ist die Verwendung einer Klemmschaltung bekannt, bei der Dioden als Schalter dienen. Störeinkopplungen vom Ansteuersignal in das Ausgangssignal lassen sich dabei recht gut unterdrücken, während das Überschwingen des Ausgangssignals sich sogar vollständig unterdrücken läßt. Die Anwendung dieses Prinzips auf eine Schaltung zur Erzeugung von Impulsen mit variablen Bezugspegeln würde jedoch dazu führen, daß die Führungsspannungsquellen für die beiden Bezugspegel mit pulsierenden Strömen belastet würden. Dadurch können aber Amplitudenfehler in den Treiberverstärkern für die beiden Signalpegel entstehen, insbesondere in den kritischen Frequenzbereichen dieser Verstärker.

Der vorliegenden Erfindung liegt die Aufgabe zugrunde, eine Schaltung der eingangs genannten Art zu schaffen, die an ihrem Ausgang störspitzen- und überschwingungsfreie Impulse mit variablen Bezugspegeln höchster Genauigkeit abgibt. Die Lösung dieser Aufgabe ist im Anspruch 1 gekennzeichnet.

Die erfindungsgemäße Schaltung gewährleistet Zustandspegel mit Spannungsfehlern unter 1‰ für jede beliebige Frequenz bzw. Impulsdauer von Gleichspannung bis zur Maximalfrequenz. Außerdem läßt sich eine höhere Arbeitsfrequenz erzielen als bei den bekannten Schaltungen. Die erfindungsgemäße Schaltung erzeugt Impulse mit sehr steilen und linearen Flanken. Zwischen den beiden Zustandspegeln lassen sich leicht relativ große Spannungsdifferenzen,zum Beispiel mehr als 10V erreichen. Ein nachfolgender Leistungsverstärker braucht daher keine oder nur eine geringe Spannungsverstärkung aufzuweisen. Der Stromverbrauch der erfindungsgemäßen Schaltung ist relativ gering.

Die erfindungsgemäße Schaltung liefert prinzipiell zwei zueinander komplementäre Ausgangssignale. Wird von diesen nur eines benötigt, so läßt sich das andere gemäß einer vorteilhaften Weiterbildung der Erfindung nach Unteranspruch 3 zur Erhöhung der Flankensteilheit der Ausgangsimpulse verwenden.

Weitere bevorzugte Ausführungsformen bzw. Weiterbildung der Erfindung sind in den übrigen Unteransprüchen gekennzeichnet. Die erfindungsgemäße Schaltung eignet sich insbesondere als Daten- oder Adressen-Treiber in Testanlagen für elektronische Baugruppen oder integrierte Schaltkreise.

Die Erfindung wird im folgenden anhand eines Ausführungsbeispiels in Verbindung mit der zugehörigen Zeichnung erläutert. In der Zeichnung zeigen

Figur 1 ein Prinzipschaltbild einer erfindungsgemäßen Schaltung zur Erzeugung von Impulsen bzw. logischen Signalen und

Figur 2  ein detailliertes Schaltbild einer bevorzugten Ausführungsform einer Schaltung, die nach dem in Figur 1
dargestellten Prinzip arbeitet.

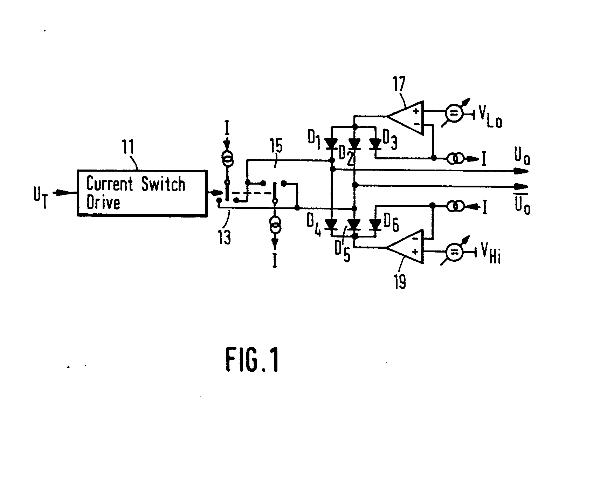

In Fig. 1 ist mit 11 eine Stromschalter-Ansteuerung bezeichnet,
die gleichzeitig zwei Stromschalter 13 und 15 betätigt. Die
Stromschalter-Ansteuerung 11 wird ihrerseits von einem Eingangssignal $u_T$ gesteuert, welches ein einfaches Taktsignal oder aber
ein binäres Datensignal sein kann. Über die Stromschalter 13
und 15 lassen sich zwei gleiche, jedoch entgegengesetzt gepolte
Feststromquellen I entsprechend dem Signal $u_T$ abwechselnd gegensinnig mit den ungleiche Dioden-Elektroden zusammenfassenden
Eckpunkten einer aus Dioden $D_1$, $D_2$, $D_4$ und $D_5$ bestehenden Diodenbrücke in Graetz-Schaltung verbinden. Mit diesen Eckpunkten
sind auch die Ausgänge der Schaltung verbunden, die zueinander
komplementäre Ausgangssignale $u_0$ bzw. $\overline{u_0}$ liefern.

Mit den gleiche Diodenelektroden zusammenfassenden Eckpunkten
der aus den Dioden $D_1$, $D_2$, $D_4$ und $D_5$ bestehenden Diodenbrücke
sind die Ausgänge von Operationsverstärkern 17 bzw. 19 verbunden.
Die Operationsverstärker 17 und 19 sind als Spannungsfolger geschaltet. Ihren positiven Eingängen werden von variablen Spannungsquellen $V_{Lo}$ bzw. $V_{Hi}$ die den gewünschten Zustandspegeln des
Ausgangssignals $u_0$ entsprechenden Spannungspegel zugeführt. Die
jeweils negativen Eingänge sind mit Rückkopplungszweigen verbunden, in denen Dioden $D_3$ bzw. $D_6$ liegen. Die Dioden $D_3$ bzw. $D_6$
haben die gleichen Polungen wie die Dioden $D_1$ und $D_2$ einerseits
bzw. $D_4$ und $D_5$ andererseits. Den Dioden $D_3$ und $D_6$ sind entsprechend ihren Polungen Ströme I eingeprägt, die betragsmäßig identisch mit den vorgenannten sind.

Wenn alle Dioden $D_1$ bis $D_6$ gleiche Eigenschaften haben, werden
durch die Operationsverstärker 17 und 19 alle Spannungsabfälle
in der Diodenbrücke ausgeregelt, so daß die Zustandspegel des
Ausgangssignals $u_0$ (bzw. des komplementären Ausgangssignals $\overline{u_0}$)
exakt den Spannungspegeln der Spannungsquellen $V_{Lo}$ bzw. $V_{Hi}$ entsprechen. Dies gilt unabhängig von der Temperatur, da sich die temperaturabhängigen Bahnwiderstände aller Dioden bei Temperaturänderungen gleichzeitig und gleichförmig verändern.

Die gleichzeitige Betätigung der Stromschalter 13 und 15 bewirkt, daß immer entweder die Dioden $D_1$ und $D_5$ oder die Dioden $D_2$ und $D_4$ der Diodenbrücke leitend sind. Dadurch können die Operationsverstärker 17 und 19 konstante Ströme abgeben bzw. aufnehmen, wenn die Ausgangsströme vergleichsweise klein sind.

Befinden sich die Stromschalter 13 und 15 in ihrer linken Schaltstellung, hat das Ausgangssignal $u_0$ den Zustandspegel $V_{Lo}$ (und das komplementäre Ausgangssignal $\overline{u_0}$ und den Zustandspegel $V_{Hi}$). In der rechten Schaltstellung der Stromschalter 13 und 15 ist dies umgekehrt.

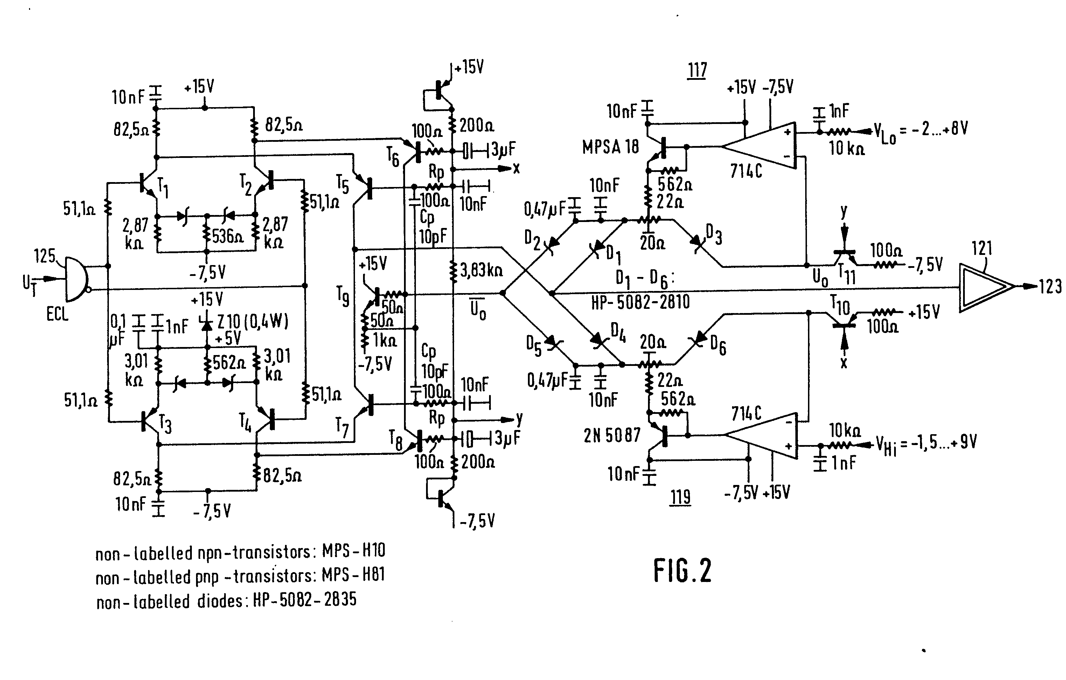

Im detaillierten Schaltbild nach Fig. 2 sind wie im Prinzipschaltbild nach Fig. 1 sechs Dioden $D_1$ - $D_6$ vorhanden. Um ein schnelles Schalten zu gewährleisten, werden Schottky-Dioden verwendet. Den Operationsverstärkern 17 und 19 gemäß Fig. 1 entsprechen Operationsverstärker-Schaltungen 117 bzw. 119, deren Kern je ein Operationsverstärker hoher Präzision (Fairchild µA 714 HC) ist.

Das Ausgangssignal $u_0$ wird über einen Stromverstärker bzw. Impedanzwandler 121 einem Ausgang 123 zugeführt. Der Stromverstärker bzw. Impedanzwandler 121 ist in Fig. 2 schematisch dargestellt. Passende Schaltungen dafür sind dem Fachmann geläufig.

Die Ansteuerung der Schaltung erfolgt wie bei der Prinzipschaltung gemäß Fig. 1 wiederum durch ein Ansteuersignal $u_T$ (Takt- oder Binärsignal) im ECL-Format. Das Ansteuersignal $u_T$ wird über ein Eingangsgatter 125 in zwei zueinander komplementäre Signale zerlegt, die die Eingangssignale einer komplementären Gegentakt-Kaskodeschaltung bilden, welche Transistoren $T_1$ bis $T_8$ enthält. Die Transistoren $T_5$ bis $T_8$ entsprechen dabei den Stromschaltern 13 und 15 in Fig. 1. Die Versorgungspotentiale der Schaltung betragen +15 V und -7,5 V. Die Pfeile x und y sind untereinander verbunden, so daß Transistoren $T_{10}$ und $T_{11}$ für die Dioden $D_6$ bzw. $D_3$ die gleichen eingeprägten Ströme liefern können wie die vorgenannten Stromschalter.

Zur Beschleunigung des Umschaltverhaltens der Stromschalter-Transistoren $T_5$ und $T_7$ und damit zur Erhöhung der Flankensteilheit der erzeugten Impulse sind Differenzierglieder vorgesehen, die Widerstände $R_p$ und Kondensatoren $C_p$ aufweisen. Über einen Emitter-Folger $T_9$ wird diesen Differenziergliedern das komplementäre Ausgangssignal $\overline{u_0}$ zugeführt.

Die Größen und Typen der im Ausführungsbeispiel nach Fig. 2 verwendeten Bauelemente sind in Fig. 2 im einzelnen angegeben. Mit der dargestellten Schaltung läßt sich eine Flankensteilheit von 2,5 V/ns bei den Ausgangsimpulsen erreichen. Die Zustandspegel sind zwischen -2 und +8V $(V_{Lo})$ bzw. -1,5 und +9V $(V_{Hi})$ einstellbar.

0056468

Patentansprüche

1. Schaltung zur Erzeugung von Impulsen bzw. logischen Signalen mit variablen Zustandspegeln, mit einer Umschalteinrichtung zum abwechselnden Aufschalten von den Zustandspegeln entsprechenden variablen Spannungsquellen auf den Ausgang der Schaltung, dadurch g e k e n n z e i c h n e t , daß die Umschalteinrichtung (11, 13, 15) eine Diodenbrücke ($D_1$, $D_2$, $D_4$, $D_5$) in Konfiguration einer Graetz-Schaltung aufweist, deren gleiche Diodenelektroden zusammenfassenden Eckpunkte mit je einer der den Zustandspegeln entsprechenden Spannungsquellen (17, 19) verbunden sind und deren ungleiche Diodenelektroden zusammenfassenden Eckpunkte mit je einem von zwei komplementären Ausgängen ($u_0$, $\overline{u_0}$) und mit je einer von zwei gleichen, aber entgegengesetzt gepolten Feststromquellen (I) verbunden sind, daß diese Feststromquellen entsprechend einem Steuersignal ($u_T$) umpolbar sind und daß die den Zustandspegeln entsprechenden Spannungsquellen Operationsverstärker enthalten, in deren Rückkopplungszweigen je eine weitere mit den Dioden der Diodenbrücke gleichartige Diode ($D_3$, $D_6$) liegt, denen der gleiche Strom wie der der Feststromquellen eingeprägt ist und die so gepolt sind, daß der Einfluß der Spannungsabfälle in der Diodenbrücke auf die Zustandspegel am Ausgang kompensiert wird.

2. Schaltung nach Anspruch 1, dadurch g e k e n n z e i c h - n e t , daß als umpolbare Feststromquellen je zwei Transistor-Stromschalter ($T_1$ - $T_8$) in komplementärer Kaskode-Anordnung vorgesehen sind.

3. Schaltung nach Anspruch 2, dadurch g e k e n n z e i c h n e t , daß einer ihrer komplementären Ausgänge ($\overline{u_0}$) über Differenzierglieder ($C_p$, $R_p$) die Umpolung der Feststromquellen ($T_5$, $T_7$), für den anderen Ausgang beschleunigt.

4.  Schaltung nach einem der Ansprüche 1 bis 3, dadurch g e k e n n z e i c h n e t , daß ihr ein schneller Stromverstärker bzw. Impedanzwandler (121) nachgeschaltet ist.

FIG.1

FIG.2

non-labelled npn-transistors: MPS-H10
non-labelled pnp-transistors: MPS-H81
non-labelled diodes: HP-5082-2835

$D_1 - D_6$: HP-5082-2810